# EUROPÄISCHE PATENTSCHRIFT

(11) **EP 3 942 696 B1**
(45) Veröffentlichungstag und Bekanntmachung des Hinweises auf die Patenterteilung: **17.04.2024**
(21) Anmeldenummer: 20707423.8
(22) Anmeldetag: 27.02.2020
(51) Int. Cl.: H03K 17/18, H03K 17/082, G01R 31/27

(54) **VERFAHREN ZUR ÜBERPRÜFUNG EINES HALBLEITERSCHALTERS AUF EINEN FEHLER**
METHOD FOR CHECKING A SEMICONDUCTOR SWITCH FOR A FAULT
PROCÉDÉ PERMETTANT DE VÉRIFIER SI UN COMMUTATEUR À SEMI-CONDUCTEURS PRÉSENTE UNE ERREUR

(30) Priorität: 18.03.2019 DE 102019106787
(43) Veröffentlichungstag der Anmeldung: 26.01.2022
(73) Patentinhaber: Webasto SE, 82131 Stockdorf (DE)
(72) Erfinder: ECK, Philipp, 82131 Stockdorf (DE)
(74) Vertreter: Prüfer & Partner mbB Patentanwälte · Rechtsanwälte
(86) Internationale Anmeldenummer: PCT/EP2020/055142
(87) Internationale Veröffentlichungsnummer: WO 2020/187543

(56) Entgegenhaltungen:
- DE-A1-102014 226 165
- JP-A- 2006 220 069
- US-A1- 2009 174 485

## Beschreibung

Die Erfindung betrifft ein Verfahren zur Überprüfung eines Halbleiterschalters auf einen Fehler, bei dem der Halbleiterschalter mit einem PWM-Signal mit veränderlichem Tastverhältnis angesteuert wird.

Um einen Halbleiterschalter (beispielsweise einen IGBT, einen MOSFET oder einen Bipolar-Transistor) auf einen Fehler, wie etwa einen Kurzschluss oder eine Unterbrechung zu überprüfen, werden Strommessungen oder Spannungsmessungen am Halbleiterschalter oder am Gesamtsystem vorgenommen, in den der Schalter integriert ist. Bei der Strommessung wird ein Strangstrom des Halbleiterschalters oder der Gesamtstrom des Gesamtsystems überwacht. Bei der Spannungsmessung wird der Spannungsabfall am Halbleiterschalter überwacht.

Oft ist es notwendig, den Halbleiterschalter mit einem PWM-Signal mit veränderlichem Tastverhältnis anzusteuern, um eine Last-/Leistungsregelung über verschiedene Umgebungsvariablen, wie etwa die Versorgungsspannung, zu gewährleisten. Eine Diagnose des Halbleiterschalters auf einen Fehler mittels eines PWM-Signals bei veränderlichem Tastverhältnis gelangt unter den folgenden beiden Szenarien an ihre Grenze:
- Ist das eingestellte Tastverhältnis sehr hoch, beispielsweise 98%, ergibt sich im Strom durch und der Spannung über dem Halbleiterschalter kein signifikanter Unterschied zu einem dauerhaften Kurzschluss.
- Das Gleiche gilt für sehr geringe Tastverhältnisse, beispielsweise 2%. Hier ergibt sich im Umkehrschluss kein wesenhafter Unterschied zu einer dauerhaften Unterbrechung.

Des Weiteren ergibt sich bei der reinen Strommessung eine starke Abhängigkeit zu Umgebungsvariablen wie beispielsweise der Versorgungsspannung.

Aus der DE10 2014 214 156A1 ist ein Verfahren zur Überprüfung der Funktionsfähigkeit eines ersten Halbleiterschalters eines Abschaltpfades eines elektrischen Laststromkreises zur Versorgung wenigstens einer Ventilspule (L) eines Bremssystems bekannt. Der erste Halbleiterschalter wird im laufenden Betrieb in einem leitenden Zustand betrieben und mittels wenigstens eines zweiten, pulsweitenmoduliert angesteuerten Halbleiterschalters erfolgt eine Stromregelung des Laststromkreises. Der erste Halbleiterschalter während des laufenden Betriebs des Kraftfahrzeugbremssystems wird derart angesteuert, dass dieser bei vorliegender Funktionsfähigkeit desselben in einen Sperrzustand umschaltet und nach einer vorgegebenen Zeitdauer des Sperrzustands eine Ansteuerung des ersten Halbleiterschalters derart vorgenommen wird, wobei dieser in einen leitenden Zustand zurückschaltet.

Aus der DE10 2010 042 292A ist ein Verfahren zur Funktionsprüfung eines elektrischen Halbleiterschalters bekannt, dessen Steueranschluss zu einem Zündzeitpunkt mittels einer Steuereinheit mit einem Zündimpuls beaufschlagt wird, wobei ein Stromflusszeitpunkt zu welchem die Stromstärke des über den Halbleiterschalter fließenden Stromes den Wert Null verlässt, erfasst wird, und eine Zeitdifferenz zwischen dem Zündzeitpunkt und dem Stromflusszeitpunkt zur Funktionsprüfung des Halbleiterschalters ausgewertet wird.

Die US 2009/174485 A1 beschreibt eine Schaltung zum Erfassen einer Überspannung bei einem engen Gate-Treiberbetrieb einer Ausgangsstufe der Klasse D. Aus der DE 10 2014 226 165 A1 ist ein adaptiver Treiber für einen Transistor bekannt.

Eine Aufgabe der Erfindung besteht darin, ein Verfahren der eingangs genannten Art zu schaffen, mit dem das Vorliegen eines Fehlers an einem Halbleiterschalter zuverlässig und kostengünstig ermittelt werden kann.

Gelöst wird diese Aufgabe durch die Merkmale des Anspruchs 1. Vorteilhafte Weiterbildungen der Erfindung sind in den Unteransprüchen festgelegt.

Das erfindungsgemäße Verfahren ist unabhängig von den meisten Umgebungsbedingungen wie der Versorgungsspannung oder der Last, da sie nur die wechselnden Spannungspegel am Halbleiter auswertet.

Auch Fehler wie zum Beispiel ein hochohmiger Kurzschluss können detektiert werden. Solche Fehler wären durch eine reine Spannungs- und Strommessung nicht erkennbar.

Das erfindungsgemäße Verfahren ist unabhängig von den meisten Umgebungsbedingungen wie etwa der Versorgungsspannung oder Last, da es ausschließlich die wechselnden Spannungspegel am Halbleiterschalter auswertet. Auch Fehler wie zum Beispiel ein hochohmiger Kurzschluss lassen sich mit dem erfindungsgemäßen Verfahren detektieren, mithin also Fehler, die durch eine reine Spannungs- und Strommessung nicht erkennbar sind. Zugunsten einer einfachen aber zuverlässigen Ermittlung von Halbleiter-Funktionsfehlern werden die über dem Halbleiterschalter erzeugten Spannungsimpulse zur Auswertung gezählt, wobei durch die Auswertung auf einen Kurzschluss oder eine Unterbrechung des Halbleiterschalters geschlossen wird, wenn dieser keine Spannungsimpulse erzeugt.

Um bei einem Tastverhältnis von 100% oder 0% eine zuverlässige und aussagekräftige Fehlerermittlung zu gewährleisten, wird die Auswertung der über dem Halbleiterschalter erzeugten Spannungspulse abgebrochen und das Vorliegen eines Fehlers über die Strommessung des Gesamtsystems ermittelt.

Die Erfindung stellt ferner eine Vorrichtung zur Durchführung des erfindungsgemäßen Verfahrens, wobei die über dem Halbleiterschalter erzeugten Spannungsimpulse von diesem über einen Kondensator an einen A/D-Wandler angelegt werden, der zur Auswertung ein digitales Signal an den Zählereingang eines Controllers anlegt. Durch den Kondensator werden nur kurzzeitige Strom- und Spannungspulse in der Diagnoseschaltung generiert. Die der Vorrichtung zugrundeliegende Schaltung kann deshalb mit wenigen, kostengünstigen Bauteilen realisiert werden.

Über eine Diodenverschaltung (Veroderung) können mehrere Halbleiterschalter, über das genannte Diagnoseverfahren, auf einen aus zwei Transistoren aufgebauten A/D Wandler gelegt werden. Ist die PWM Ansteuerung der zu diagnostizierenden Halbleiter phasenversetzt, können somit alle Halbleiter über einen A/D Wandler und einen Timer Eingang am Controller überwacht werden.

Nachfolgend wir die Erfindung anhand der Zeichnung näher erläutert; in dieser zeigen:
Fig. 1 zeigt das Schaltungsdiagramm einer ersten Ausführungsform der erfindungsgemäßen Vorrichtung zur Durchführung des erfindungsgemäßen Verfahrens zur Überprüfung eines Halbleiterschalters auf einen Fehler, und
Fig. 2 zeigt schematisch eine Abwandlung der Vorrichtung von Fig. 1 zur Überprüfung einer Schaltung mit zwei Halbleiterschaltern auf einen Fehler.

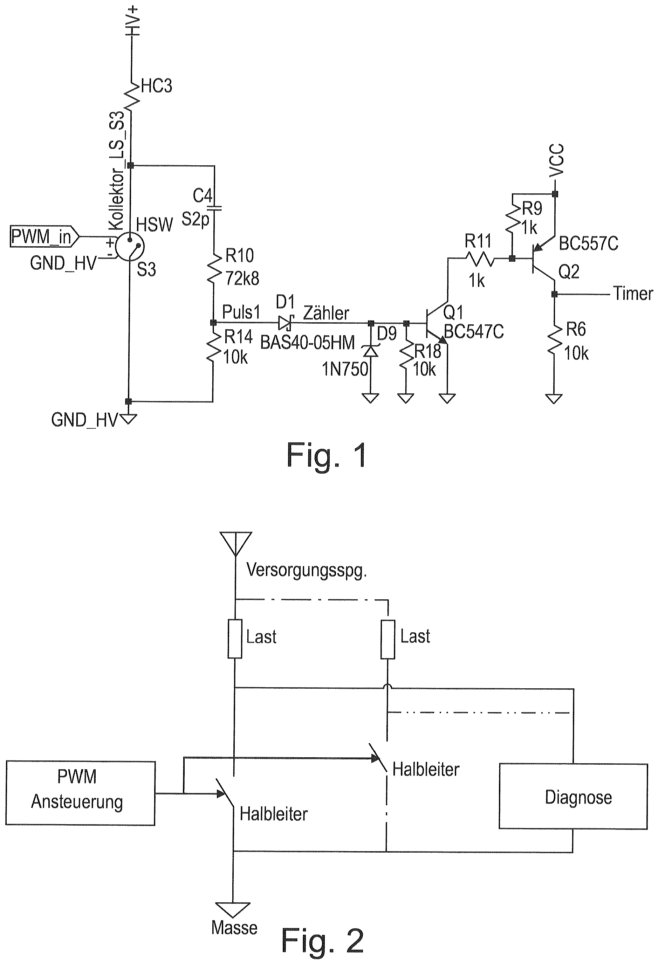

Die in Fig. 1 gezeigte Vorrichtung basiert auf einer Schaltung zur Überprüfung eines Halbleiterschalters auf einen Fehler, bei dem der Halbleiterschalter mit einem PWM-Signal mit veränderlichem Tastverhältnis angesteuert wird. Der Halbleiterschalter S3 liegt einerseits mit seinem Kollektor über einen Lastwiderstand HC3 an einer positiven Spannung HV+ und andererseits an einer Masse GND_HC an. Am Eingang des Halbleiterschalters liegt ein PWM-Signal an.

Über einen Kondensator C4 werden vom Kollektor des Halbleiterschalters die Spannungspulse, die sich im PWM-Schaltfall ergeben ausgefiltert, da nur diese für die Diagnose des Schalters benötigt werden. Durch diese Beschaltung ergibt sich der weitere Vorteil, dass die restliche Schaltung nicht dauerhaft am Versorgungspotential anliegt, sondern nur einzelne Pulse belastend wirken. Hierdurch kann die Bauteileanzahl erheblich reduziert werden, da keine dauerhaften Verluste generiert werden.

Der Kondensator liegt über einen Spannungsteiler, der einen Widerstand R10 und einem Widerstand R7 umfasst, an Masse GND_HC an. Dieser Spannungsteiler teilt die generierten Spannungspulse auf geringere Werte und reduziert den Pulsstrom durch C4.

Über eine Diode D1 werden die vom Kondensator C4 durchgelassenen Impulse als positive Pulse an eine nachfolgende Signalaufbereitung weitergegeben. An dieser Stelle können nicht gezeigte weitere Diagnosezweige mit ihren Kathoden zu einer Disjunktion (ODER-Verknüpfung) verknüpft werden (sofern diese einen Phasenversatz aufweisen).

Eine nach der ODER-Verknüpfung angeschlossene Zener Diode D9 schützt die nachfolgende Signalaufbereitungsmittel vor Überspannung. Dieses Mittel umfasst zwei Transistoren Q1 und Q2, die über Widerstände R18, R11 bzw. R6 und R 9 zu einem einfachen A/D-Wandler verschaltet sind und aus dem positiven Puls an der Kathode der Diode D9 ein Digitalsignal "Timer" erzeugt, das dem Zählereingang eines nicht gezeigten Controllers zugeführt wird. Auf dem Controller erfolgt eine Diagnose des Halbleiterschalters auf Software-Ebene, wobei die eingehenden Pulse "Timer" gezählt werden. Bei einem Fehler des Halbleiterschalters, sei es ein Kurzschluss oder eine Unterbrechung, werden keine Pulse generiert. Dadurch vermag die Software den Fehler zu erkennen und geeignete Maßnahmen einzuleiten.

Bei einem Tastverhältnis von 0% und 100% wird bevorzugt diese Diagnose auf Softwareebene abgeschaltet und es erfolgt eine Fehlerdiagnose über den Gesamtstrom der Schaltung.

Durch den Kondensator C4 werden nur kurzzeitige Strom- und Spannungspulse in der Diagnoseschaltung generiert. Hierdurch kann die Schaltung mit wenigen, kostengünstigen Bauteilen realisiert werden.

Das Funktionsprinzip der Schaltung von Fig. 1 ist in Fig. 2 für den Fall der gleichzeitigen Untersuchung von zwei Halbleiterschaltern auf Fehler gezeigt.

## Patentansprüche

1. Verfahren zur Überprüfung eines Halbleiterschalters (S3) auf einen Fehler, bei dem der Halbleiterschalter (S3) mit einem PWM-Signal mit veränderlichem Tastverhältnis angesteuert wird, wobei wenn der Halbleiterschalter (S3) mit einem Tastverhältnis von 100% oder 0% betrieben wird, die Strommessung des Gesamtsystems ausgewertet wird, während dann, wenn der Halbleiterschalter (S3) mit einem Tastverhältnis zwischen 0% und 100% betrieben wird, die erzeugten Spannungspulse über dem Halbleiterschalter (S3) ausgewertet werden, wobei die über dem Halbleiterschalter (S3) erzeugten Spannungsimpulse zur Auswertung gezählt werden, und wobei durch die Auswertung auf einen Kurzschluss oder eine Unterbrechung des Halbleiterschalters (S3) geschlossen wird, wenn dieser keine Spannungsimpulse erzeugt.

2. Verfahren nach Anspruch 1, wobei bei einem Tastverhältnis von 100% oder 0% die Auswertung abgebrochen und ein Fehler über die Strommessung des Gesamtsystems ermittelt wird.

3. Vorrichtung zur Durchführung des Verfahrens nach einem der Ansprüche 1 bis 2, wobei die über dem Halbleiterschalter (S3) erzeugten Spannungsimpulse von diesem über einen Kondensator (C4) abgegriffen und an einen A/D-Wandler (Q1, Q2) angelegt werden, der zur Auswertung ein digitales Signal (Timer) an den Zählereingang eines Controllers anlegt.

4. Vorrichtung nach Anspruch 3, wobei die vom Kondensator abgegriffenen Spannungsimpulse mittels einer Diode (D4) in an den A/D-Wandler (Q1, Q2) angelegte positive Impulse umgesetzt werden.

## Claims

1. Method for checking a semiconductor switch (S3) for a fault, in which the semiconductor switch (S3) is driven with a PWM signal with variable duty cycle, wherein, when the semiconductor switch (S3) is operated with a duty cycle of 100% or 0% the current measurement of the overall system is evaluated, while, when the semiconductor switch is operated with a duty cycle between 0% and 100% the voltage pulses generated across the semiconductor switch are evaluated, wherein the voltage pulses generated across the semiconductor switch (S3) are counted for the evaluation, and as a result of the evaluation a short circuit or an open circuit of the semiconductor (S3) switch is detected if the latter does not generate voltage pulses.

2. Method according to claim 1, wherein at a duty cycle of 100% or 0% the evaluation is aborted and a fault is determined via the current measurement of the overall system.

3. Device for carrying out the method according to one of claims 1 to 2, wherein the voltage pulses generated across the semiconductor switch (S3) are tapped off from the same via a capacitor (C4) and applied to an A/D converter (Q1, Q2), which applies a digital signal (Timer) to the counter input of a controller for the evaluation.

4. Device according to claim 3, wherein the voltage pulses tapped off via the capacitor are converted by means of a diode (D4) into positive pulses that are applied to the A/D converter (Q1, Q2).

## Revendications

1. Procédé de vérification d'un commutateur à semi-conducteur (S3) pour rechercher un défaut, procédé dans lequel le commutateur à semi-conducteur (S3) est commandé avec un signal PWM ayant un rapport cyclique variable, la mesure du courant de tout le système étant évaluée lorsque le commutateur à semi-conducteur (S3) fonctionne avec un rapport cyclique de 100 % ou 0 %, tandis que les impulsions de tension générées aux bornes du commutateur à semi-conducteur (S3) sont évaluées lorsque le commutateur à semi-conducteur (S3) fonctionne avec un rapport cyclique compris entre 0 % et 100 %, les impulsions de tension générées aux bornes du commutateur à semi-conducteur (S3) étant comptées pour l'évaluation, et l'évaluation permettant de conclure qu'il y a un court-circuit ou une interruption du commutateur à semi-conducteur (S3) si celui-ci ne génère aucune impulsion de tension.

2. Procédé selon la revendication 1, l'évaluation état arrêtée dans le cas d'un rapport cyclique de 100 % ou 0 %, et une erreur étant déterminée par la mesure de courant de tout le système.

3. Dispositif destiné à mettre en œuvre le procédé selon l'une des revendications 1 à 2, les impulsions de tension générées par l'interrupteur à semi-conducteur (S3) étant prélevées sur ce dernier par le biais d'un condensateur (C4) et appliquées à un convertisseur A/N (Q1, Q2), qui applique un signal numérique (timer) à l'entrée du compteur d'un contrôleur pour effectuer l'évaluation.

4. Dispositif selon la revendication 3, les impulsions de tension prélevées sur le condensateur étant converties en impulsions positives appliquées sur le convertisseur A/D (Q1, Q2) au moyen d'une diode (D4) .
